# FASCICULE DE BREVET EUROPEEN

(11) **EP 3 028 312 B1**
(45) Date de publication et mention de la délivrance du brevet: **17.04.2019**
(21) Numéro de dépôt: 14758161.5
(22) Date de dépôt: 28.07.2014
(51) Int. Cl.: H01L 31/042, G02F 1/1335

(54) **DISPOSITIF D'AFFICHAGE RÉTROÉCLAIRÉ AVEC CELLULES PHOTOVOLTAÏQUES INTÉGRÉES**
HINTERGRUNDBELEUCHTETE ANZEIGEVORRICHTUNG MIT INTEGRIERTEN PHOTOVOLTAISCHEN ZELLEN
BACKLIT DISPLAY DEVICE WITH INTEGRATED PHOTOVOLTAIC CELLS

(30) Priorité: 29.07.2013 FR 1301822
(43) Date de publication de la demande: 08.06.2016
(73) Titulaire: Sunpartner Technologies, 13090 Aix-en-Provence (FR)
(72) Inventeur: KERZABI, Badre, 13090 Aix en Provence (FR)
(74) Mandataire: Nicolle, Olivier
(86) Numéro de dépôt international: PCT/FR2014/000178
(87) Numéro de publication internationale: WO 2015/015064

(56) Documents cités:
- US-A1- 2007 102 035
- US-A1- 2010 245 731
- US-A1- 2010 289 984
- US-A1- 2011 063 729
- US-A1- 2011 109 853
- US-A1- 2012 236 540

## Description

### Domaine technique de l'invention

L'invention concerne le domaine des écrans d'affichage rétroéclairés, et plus particulièrement les écrans d'affichage rétroéclairés pour dispositifs électroniques portables, tels que des téléphones, présentant des cellules photovoltaïques intégrées dans la face d'affichage.

### Etat de la technique

Des écrans d'affichage comportant des zones d'images rétroéclairées sont couramment utilisés dans des dispositifs électroniques portables.

On entend ici par une zone d'image «rétroéclairée» une zone d'image qui est située devant une source lumineuse qui l'éclaire par l'arrière. La «zone d'image» peut par exemple être un pixel, une pluralité de pixels ou une partie d'un pixel (par exemple un pixel à cristaux liquides), ou encore une bande de film sur laquelle a été imprimée une image. Dans un écran rétroéclairé, une source de lumière diffuse est placée derrière le plan des pixels, afin d'améliorer le contraste.

Les dispositifs portables disposent en général d'une alimentation électrique par batteries, dont la durée d'autonomie est un facteur de confort d'utilisation important. Pour augmenter cette durée d'autonomie, on a intégré des photopiles dans ces dispositifs portables, qui produisent une partie du courant nécessaire au fonctionnement dudit dispositif. Dans la mesure où l'espace disponible pour disposer des photopiles sur la surface externe desdits dispositifs portables est très réduit, il serait souhaitable d'intégrer les photopiles dans l'écran d'affichage.

L'état de la technique montre un certain nombre d'exemples pour une telle intégration. Une première approche consiste à déposer des cellules photovoltaïques semi-transparentes (voir EP 1 174 756 (ETA), US 7,206,044 (Motorola), WO 2009/052326, US 2010/284055, WO 2009/065069 (Qualcomm), US 2010/245731 (Intel)).

Une autre approche consiste à déposer des couches photovoltaïques sous la forme de bandes entre lesquels passe la lumière provenant des pixels (voir US 2002/0119592 (BP), US 4,795,500 (Sanyo), WO 2009/098459 (M-Solv)). Toutes ces approches conduisent à des écrans qui sont soit peu lumineux, soit la superficie des cellules photovoltaïques, qui est, pour un type de cellule donnée, proportionnelle à l'énergie convertie, est faible.

Le document US 2007/0102035 (X. Yang) propose un système à lentilles disposé derrière l'écran d'affichage qui focalise la lumière rétroéclairante sur des zones non recouvertes de photopiles, alors que des photopiles couvrant des zones disposées sur la surface de l'écran collectent la lumière diffuse ambiante.

Cependant, d'une manière générale, ces photopiles ne doivent dégrader ni les caractéristiques d'imagerie ni la luminosité de l'écran dans lequel elles ont été intégrées, et c'est pourquoi la surface totale disponible pour ces photopiles est en fait très réduite. En effet, la largeur des photopiles ne peut pas être significativement supérieure à l'espace entre deux pixels, un espace que l'on souhaite minimiser afin d'améliorer la résolution de l'écran. Si les photopiles sont plus grandes, et a *fortiori* lorsqu'elles recouvrent partiellement la surface des pixels comme c'est le cas dans le mode de réalisation discuté ci-dessus du document US 2007/0102035, la luminosité et la résolution de l'image générée par l'écran se trouvent dégradées. Ce même document comporte un autre mode de réalisation dans lequel la lumière de rétroéclairage est focalisée dans l'espace entre les photopiles par une lentille située entre la source lumière de rétroéclairage et le substrat sur lequel se trouve le réseau de pixels. Ce mode de réalisation présente l'inconvénient de nécessiter un positionnement extrêmement précis de la lentille, à la fois en ce qui concerne sa position latérale, mais surtout sa distance par rapport aux photopiles, ce qui nuit à une industrialisation aisée de ce mode de réalisation. Par ailleurs, il ne permet pas d'intégrer la source de lumière pour le rétroéclairage directement dans le substrat des transistors à effet de champ qui pilotent les cristaux liquides formant les pixels de l'écran.

Récemment, ces derniers systèmes d'écrans rétroéclairés munis de bandes de photopiles intégrées sur la face d'affichage ont été le point de départ d'une amélioration significative par l'utilisation de réseaux lenticulaires, tel que décrit dans les documents WO 2012/104503 et WO 2013/054010 (WYSIPS), capables de focaliser la lumière provenant des pixels de l'écran rétroéclairé entre les bandes et augmentent ainsi, à fraction surfacique constante des bandes photovoltaïques, la luminosité de l'écran.

La fabrication des réseaux lenticulaires est réalisée par dépôt ou par déformation de matière sur un substrat de manière à lui conférer une structure en bandes qui représentent la forme des lentilles du réseau lenticulaire. Dans le cas d'un dépôt de matière, le procédé employé est un coulage d'un polymère liquide ou semi-liquide dans un moule (typiquement en polydiméthylsiloxane), puis on provoque la solidification du polymère. Dans le cas d'une déformation de matière, le procédé est un emboutissage du polymère solide par un moule. Dans les deux procédés précités, la dernière étape, qui consiste au démoulage, est une opération délicate, car compte tenu de la grande surface des ondulations du réseau lenticulaire, le polymère ne se détache pas facilement du moule : il y a un risque de casser le réseau lenticulaire et/ou son substrat. Par ailleurs, la surface des lentilles du réseau lenticulaire peut être dégradée lors du démoulage et des manipulations successives. Et finalement, l'emploi d'un moule nécessite soit de traiter la surface du moule d'un agent de séparation, soit d'utiliser des polymères qui adhèrent le moins possible au verre, ces polymères étant éventuellement dotés d'additifs spécifiques, qui ne doivent cependant pas dégrader la transparence optique du polymère solidifié, et qui ne doivent pas accélérer le vieillissement du polymère.

Le problème que la présente invention souhaite résoudre est donc celui de présenter un procédé de fabrication simplifié qui évite au moins certains des inconvénients précités, et qui conduit à un produit performant et durable.

### Objets de l'invention

Selon l'invention, le problème est résolu par un nouveau procédé de fabrication d'un nouveau module photovoltaïque, et par l'intégration de ce dernier dans un dispositif d'affichage à cellules photovoltaïques intégrées, qui représente un objet de l'invention. Ce module photovoltaïque comporte :
(a) un réseau de zones d'image émettant de la lumière ou rétroéclairés par une source de lumière placée derrière le réseau de zones d'images ;
(b) un réseau formé par une pluralité de zones de cellules photovoltaïques et une pluralité d'orifices, dans lequel réseau au moins deux zones de cellules photovoltaïques voisines forment un orifice,
(c) un réseau lenticulaire permettant de focaliser la lumière émise par lesdites zones d'image dans lesdits orifices.

Un premier objet de l'invention est un procédé de fabrication d'un tel module photovoltaïque, notamment pour écran d'affichage rétroéclairé, ledit module photovoltaïque comportant un réseau comportant une pluralité de zones de cellules photovoltaïques et une pluralité de zones libres dites « orifices », et ledit module photovoltaïque comportant un réseau lenticulaire apte à focaliser la lumière dans les orifices, dans lequel procédé de fabrication :
- on approvisionne un substrat comportant un réseau présentant une pluralité de zones de cellules photovoltaïques et une pluralité d'orifices ;
- on approvisionne un polariseur texturé comportant une surface texturée composée d'un réseau de sommets et de vallées qui représentent la forme négative dudit réseau d'éléments optiques, de manière à ce que les vallées dudit réseau d'éléments optiques sont représentées sur ladite surface texturée dudit polariseur texturé par des sommets et les sommets dudit réseau d'éléments optiques sont représentés par des vallées de la surface du polariseur texturé ;
- on fixe la face texturée dudit polariseur texturé sur la face dudit substrat qui comporte lesdites cellules photovoltaïques, à l'aide d'un polymère transparent liquide ou semi-liquide, le positionnement respectif dudit polariseur texturé et dudit substrat étant tel que les sommets ou les vallées dudit polariseur texturé sont approximativement alignés sur le centre desdites zones de cellules photovoltaïques ou sur le centre desdits orifices ;
- on procède à la réticulation dudit polymère pour obtenir une liaison entre ledit polariseur texturé et ledit substrat comportant des zones de cellules photovoltaïques.

Dans un mode de réalisation ledit réseau de cellules photovoltaïques est au moins partiellement recouvert d'un réseau de zones d'images colorées.

Le procédé selon l'invention peut comprendre des étapes de fabrication dudit polariseur texturé, à savoir les étapes suivantes :
∘ on approvisionne un premier polariseur,
∘ on dépose sur l'une de ses surfaces un polymère liquide ou semi-liquide,
∘ on imprime à ce polymère la texture souhaitée pour obtenir ladite surface texturée, par exemple à l'aide d'un rouleau ou d'un tampon texturé,
∘ on procède à la réticulation dudit polymère,
sachant que ledit polymère, après réticulation, doit être optiquement transparent. Ledit polymère peut être le même matériau que celui dudit premier polariseur.

Alternativement, le procédé selon l'invention peut comprendre les étapes de fabrication suivantes dudit polariseur texturé :
∘ on approvisionne un premier polariseur,
∘ on imprime à l'une de ses surfaces la texture souhaitée pour obtenir ladite surface texturée, par exemple à l'aide d'un rouleau ou d'un tampon texturé.

Ledit polymère peut être le même matériau que celui dudit premier polariseur. Qu'il s'agisse ou non du même matériau, on préfère que l'indice optique dudit polymère soit à au moins ± 0,05 près le même que celui du polariseur (et de préférence à au moins ± 0,03 près).

Ledit polariseur texturé peut être fabriqué par un procédé dans lequel
∘ on approvisionne un polariseur,
∘ on imprime à l'une de ses surfaces la texture souhaitée pour obtenir ladite surface texturée, par exemple à l'aide d'un rouleau ou d'un tampon texturé.

Alternativement, ledit polariseur texturé peut être fabriqué par un procédé dans lequel
∘ on approvisionne un premier polariseur,
∘ on dépose sur l'une de ses surfaces un polymère liquide ou semi-liquide,
∘ on imprime à ce polymère la texture souhaitée pour obtenir ladite surface texturée, par exemple à l'aide d'un rouleau ou d'un tampon texturé,
∘ on procède à la réticulation dudit polymère,
sachant que ledit polymère, après réticulation, doit être optiquement transparent.

Ce nouveau procédé de fabrication d'un module photovoltaïque évite le démoulage du réseau lenticulaire, quand bien même le réseau lenticulaire est toujours fabriqué par un procédé de moulage : selon l'invention le moule est un composant du dispositif même, à savoir soit le premier polariseur soit une couche optique en contact avec le premier polariseur.

Encore un autre objet selon l'invention est un module photovoltaïque à réseau lenticulaire susceptible d'être obtenu par l'un des procédés selon l'invention, caractérisé en ce que lesdites cellules photovoltaïques sont des cellules en couche mince de matériaux inorganiques et/ou organiques, par exemple à base de silicium amorphe ou microcristallin, à base de CdTe ou à base de cuivre - indium - gallium - sélénium ou à base de polymères.

Encore un autre objet de l'invention est un dispositif d'affichage avec cellules photovoltaïques et réseau lenticulaire intégrés, caractérisé en ce qu'il comprend, dans l'ordre et en suivant la direction de la lumière émise :
- une source de lumière, telle qu'une plaque lumineuse ;
- de manière optionnelle, un dispositif de collimation, qui peut comporter une pluralité de films individuels ;
- un polariseur (appelé ici « deuxième polariseur ») ;
- un modulateur électro-optique, notamment à cristaux liquide ;
- un polariseur (appelé ici « premier polariseur ») ;
- une couche optique texturée, qui présente avantageusement un indice optique proche (de préférence à au moins ± 0,05 près, et encore plus préférentiellement à au moins ± 0,03 près) voire identique à celui dudit premier polariseur, sachant que cette couche optique texturée peut être absente si c'est la surface dudit premier polariseur lui-même qui a été texturée convenablement avec les ondulations du réseau lenticulaire pour pouvoir agir comme moule pour la fabrication dudit réseau lenticulaire ;
- un réseau lenticulaire ;
- un réseau de zones d'images colorées ;
- un réseau de zones de cellules photovoltaïques ;
- un substrat qui protège ledit réseau de zones de cellules photovoltaïques, et sur lequel lesdites zones de cellules photovoltaïques peuvent avoir été déposées lors de leur fabrication.

Encore un autre objet de l'invention est un dispositif d'affichage avec cellules photovoltaïques et réseau lenticulaire intégrées, caractérisé en ce qu'il comporte, dans l'ordre et en suivant la direction de la lumière émise :
- une source de lumière, telle qu'une plaque lumineuse ;
- optionnellement, un dispositif de collimation, qui peut comporter une pluralité de films individuels ;
- un polariseur dit « deuxième polariseur » ;
- un modulateur électro-optique, notamment à cristaux liquide ;
- un réseau de zones d'images colorées ;
- un polariseur dit « premier polariseur » ;
- une couche optique texturée avec les ondulations du réseau lenticulaire, qui présente avantageusement un indice optique proche (de préférence à au moins ± 0,05 près, et plus préférentiellement à au moins ± 0,03 près) voire identique à celui dudit premier polariseur avec lequel elle est en contact ; sachant que cette couche optique texturée peut être absente si c'est la surface du deuxième polariseur lui-même qui a été texturée convenablement avec les ondulations du réseau lenticulaire pour pouvoir agir comme moule pour la fabrication dudit réseau lenticulaire ;
- un réseau lenticulaire ;
- un réseau de zones de cellules photovoltaïques ;
- un substrat apte à protéger ledit réseau de zones de cellules photovoltaïques, et sur lequel lesdites zones de cellules photovoltaïques peuvent avoir été déposées lors de leur fabrication.

Dans un mode de réalisation particulier desdits dispositifs d'affichage selon l'invention :
- lesdites zones de cellules photovoltaïques sont des bandes photovoltaïques parallèles,
- lesdits orifices sont des bandes libres, deux bandes photovoltaïques voisines délimitant une bande libre ;
- ledit réseau lenticulaire comporte une juxtaposition de lentilles rectilignes identiques, dont l'axe longitudinal est parallèle aux bandes des cellules photovoltaïques.

Ledit réseau lenticulaire peut être est constitué d'une pluralité de bandes lenticulaires comportant des lentilles cylindriques ou d'une pluralité de bandes lenticulaires de lentilles sphériques hexagonales.

Le dispositif selon l'invention peut comprendre un écran tactile sur sa face externe, dirigée vers l'utilisateur.

Le dispositif d'affichage selon l'invention comporte un réseau de zones d'images. Il peut s'agir de pixels. Le terme « pixel » englobe ici soit un pixel individuel correspondant à un filtre coloré de couleur unique, soit une pluralité de parties d'un pixel correspondant à plusieurs filtres colorés (typiquement trois, à savoir de couleur bleue, rouge et verte) qui coopèrent afin de créer une tâche lumineuse (typiquement perçue par l'observateur comme un point lumineux) d'une couleur déterminée en fonction de l'intensité émise par chaque zone. Ces zones d'images ou pixels forment un réseau ordonné. Les techniques d'affichage par pixels sont connues de l'homme du métier. L'écran selon l'invention peut être rétroéclairé au moyen d'une source de lumière placée derrière le réseau de zones d'images ou pixels (par exemple dans le cas d'un écran de type LCD (Liquid Crystal Display) ou dans le cas d'un panneau publicitaire comprenant des zones d'images sous la forme de bandes parallèles imprimées (de préférence translucides). L'écran peut être un écran souple ou rigide. Il peut comporter sur sa face externe une couche ou un film tactile, de manière à permettre l'entrée de données par l'utilisateur par l'intermédiaire d'une voie tactile.

Dans d'autres modes de réalisation, les zones d'images, pixels et/ou parties de pixels sont ordonnés de manière à ce que différents groupes de zones d'images, pixels et/ou parties de pixels génèrent des images différentes.

Le module photovoltaïque selon l'invention comprend par ailleurs une pluralité de zones (ou bandes) de cellules PV (l'abréviation «PV» signifie ici « photovoltaïque ») qui alternent avec une pluralité d'orifices (i.e. de zones ne comportant pas de cellules photovoltaïques, par exemple des bandes libres) par lesquelles la lumière en provenance des zones d'image ou des pixels peut passer. Lesdites zones de cellules photovoltaïques (par exemple lesdites bandes photovoltaïques) et lesdits orifices (par exemple lesdites bandes libres) peuvent avoir une dimension, longueur ou largeur quelconque ; elles peuvent s'étaler sur toute la longueur ou largeur du dispositif d'affichage selon l'invention, ou sur une partie seulement ; ledit dispositif d'affichage peut alors comprendre plusieurs ensembles de zones de cellules photovoltaïques. Lesdites zones ou bandes de cellules photovoltaïques peuvent être déposées sur un substrat approprié, par exemple une plaque ou un film ; nous appelons par la suite les zones ou bandes de cellules photovoltaïques déposées sur leur substrat une « plaque photovoltaïque », ce qui n'implique nullement qu'elle soit mécaniquement rigide. Au contraire, ledit substrat peut être souple, flexible. Lesdites zones de cellules photovoltaïques peuvent avoir une forme quelconque, par exemple rectangulaire. Lesdites zones de cellules photovoltaïques (par exemple lesdites bandes photovoltaïques) et lesdits orifices (par exemple lesdites bandes libres) peuvent être équidistantes, ou former autrement un réseau ordonné. Grâce aux orifices (par exemple les bandes libres), la plaque photovoltaïque est partiellement transparente ; la transmission optique dite externe (Tₑₓₜ) de la plaque photovoltaïque est déterminée en grande partie par la fraction surfacique qu'occupent les cellules photovoltaïques, et par leur transmission optique intrinsèque.

Dans tous les modes de réalisation, une zone ou bande de cellules photovoltaïques peut comporter une ou plusieurs cellules photovoltaïques, et dans le deuxième cas ces cellules photovoltaïques peuvent être de nature (matériaux et/ou structure), forme et dimension identiques ou différentes, et elles peuvent être mises électriquement en série et/ou en parallèle. Lesdites zones de cellules photovoltaïques (par exemple lesdites bandes photovoltaïques) sont avantageusement des cellules photovoltaïques en couches minces à base de silicium amorphe ou microcristallin, car ce type de cellules est particulièrement adapté pour convertir de la lumière de faible intensité (lumière diffusante, lumière à l'intérieur de pièces) ; mais on peut aussi réaliser ces cellules photovoltaïques en toute autre technologies adaptées, par exemple à base de CdTe ou CIGS (cuivre - indium - gallium - sélénium) ou à base de polymères. Il peut s'agir de jonctions de type p-i-n ou p-n, ou encore de cellules tandem, i.e. comportant deux cellules superposées qui absorbent préférentiellement une partie différente du spectre lumineux. Elles peuvent être conçues pour convertir la lumière visible et/ou la lumière ultra-violette et/ou la lumière infrarouge en électricité. Elles peuvent être au moins partiellement transparentes à la lumière visible. Elles peuvent être protégées par une couche de protection, qui est avantageusement pourvue d'une couche antireflet.

Le dispositif d'affichage selon l'invention comprend également une pluralité de lentilles. Ces lentilles peuvent être identiques ou différentes.
Dans un mode de réalisation, le réseau lenticulaire primaire comprend une juxtaposition de lentilles rectilignes identiques, dont l'axe longitudinal est parallèle aux bandes de cellules photovoltaïques.

Avantageusement, les surfaces respectives du réseau photovoltaïque, du réseau lenticulaire et du réseau de pixels sont soit planes (et sensiblement parallèles), soit courbes (tout en restant équidistantes), notamment dans le cas où l'écran est un écran souple. Les réseaux lenticulaires peuvent être réalisés en une matière plastique transparente appropriée, telle que le PET.

D'une manière générale, les lentilles formant le réseau lenticulaire peuvent avoir toute forme et caractéristique appropriées ; il peut s'agir notamment de lentilles plan-convexes ou biconvexes, ou encore de lentilles sphériques et/ou asphériques, ou encore de lentilles symétriques ou asymétriques, ou encore les lentilles à variation d'indice.

Plus particulièrement, le réseau de zones d'images est avantageusement positionné par rapport au réseau lenticulaire et par rapport à la plaque photovoltaïque de manière à ce que la lumière provenant de chaque zone d'image ou partie de zone d'image et reçue par la lentille correspondante du réseau lenticulaire soit déviée et/ou concentrée par cette lentille de manière à passer entièrement, ou au moins en grande partie, au travers de l'un des orifices de la plaque photovoltaïque.

### Figures

- La figure 1a montre schématiquement en coupe transversale la structure optique d'un écran d'affichage avec bandes photovoltaïques selon l'état de la technique. La figure 1b montre schématiquement en coupe transversale un extrait de ce dispositif en focalisant l'attention sur la géométrie du substrat portant les cellules photovoltaïques et sur la géométrie du réseau lenticulaire.
- Les figures 2a, 2b, 2c, 2d, 2e, 2f et 2g montrent schématiquement en coupe transversale des objets qui illustrent différentes étapes d'un procédé selon l'invention.
- La figure 3 montre schématiquement en coupe transversale un produit selon l'invention qui peut être fabriqué en mettant en oeuvre les étapes du procédé illustré sur la figure 2.
- Les figures 4a, 4b, 4c, 4d, 4e et 4f montrent schématiquement en coupe transversale des objets qui illustrent différentes étapes d'un autre procédé selon l'invention.
- La figure 5 montre schématiquement en coupe transversale un produit selon l'invention qui peut être fabriqué en mettant en oeuvre les étapes du procédé illustré sur la figure 4.
- La figure 6 montre un réseau lenticulaire composé de lentilles cylindriques (figure 6a) ou sphériques hexagonales (figure 6b), ainsi que les paramètres géométriques de ces réseaux lenticulaires vus en coupe (figure 6c).

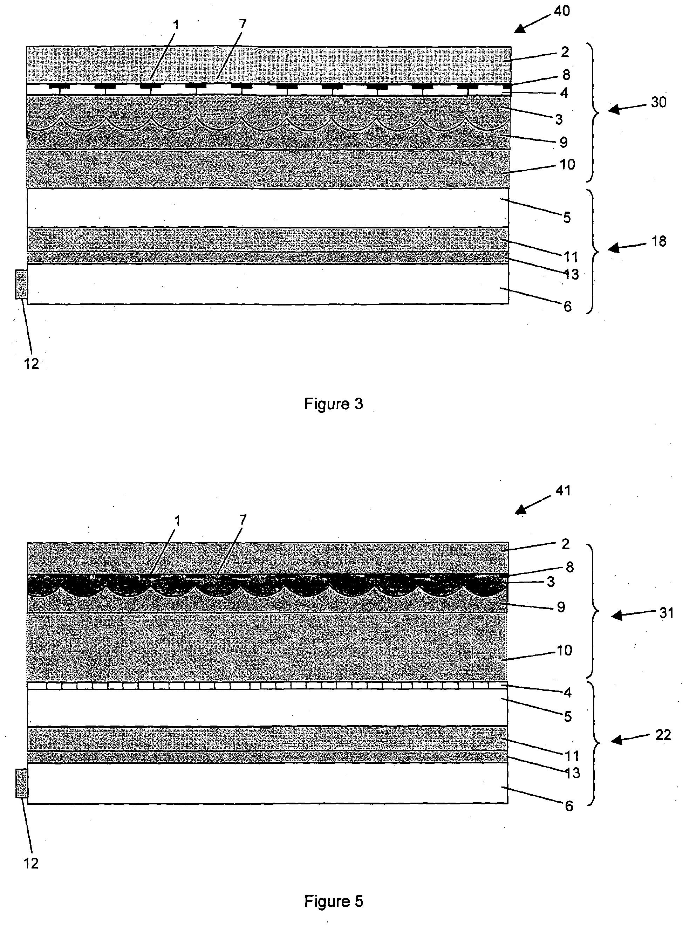

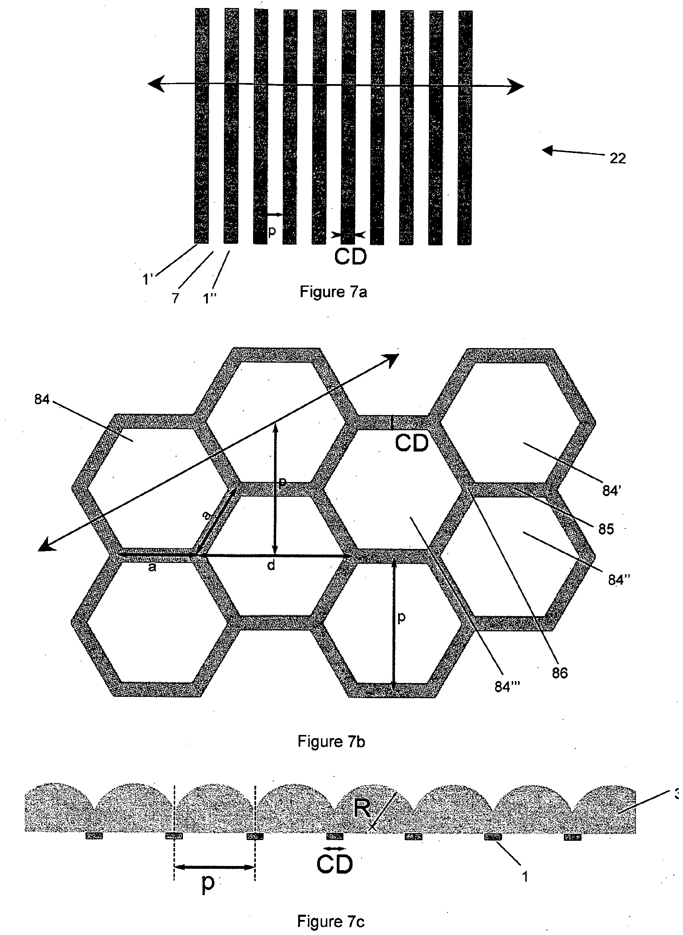

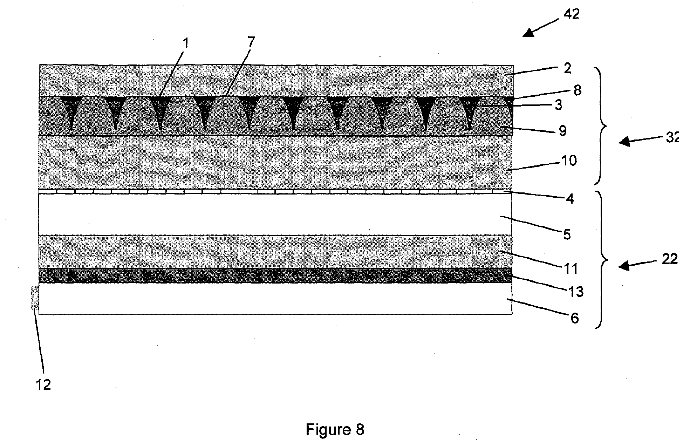

- La figure 7 définit des paramètres géométriques des zones de cellules photovoltaïques dans le cas où les zones de cellules photovoltaïques forment un réseau de bandes parallèles dont deux bandes voisines délimitent une bande libre (figure 7a), dans le cas où les cellules photovoltaïques ont la forme de bandes dont chacune délimite deux ou (aux points de contact) trois zones hexagonales représentant les orifices (figure 7b), et dans le cas où les cellules photovoltaïques sont associées au réseau lenticulaire (figure 7c).- La figure 8 montre schématiquement en coupe transversale une variante du produit selon l'invention décrit à la figure 5.

### Description détaillée

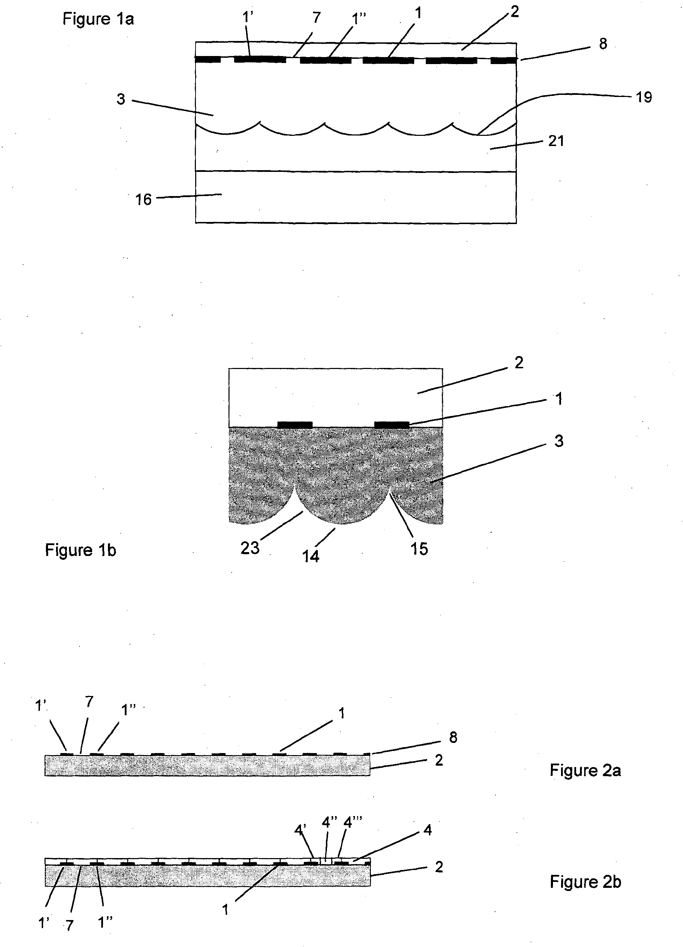

La figure 1a montre schématiquement un écran d'affichage de type connu comportant un réseau lenticulaire **3** capable de focaliser la lumière en provenance d'un dispositif d'affichage **16** dans l'espace (« orifice ») **7** entre les bandes photovoltaïques **1'**,**1"**. Ces dernières sont déposées sur un substrat **2**. L'espace **21** entre le dispositif d'affichage **16** et la surface des lentilles **19** du réseau lenticulaire **3** peut être un espace d'air, ou encore rempli d'une colle optiquement transparente.

La figure 1b montre schématiquement en section transversale une partie de la structure optique d'un écran connu. Les cellules photovoltaïques **1**, typiquement sous la forme de bandes parallèles, sont déposées sur un substrat **2**, typiquement en verre, et sont pris en sandwich par le réseau lenticulaire **3**. Ce dernier comporte des ondulations **23** parallèles comportant des sommets **14** et des vallées **15**, disposées parallèles aux bandes photovoltaïques **1**, de manière à ce que les sommets **14** se situent au milieu entre deux bandes photovoltaïques **1**, et les vallées **15** au milieu des bandes photovoltaïques **1**. Lesdites ondulations agissent comme lentilles.

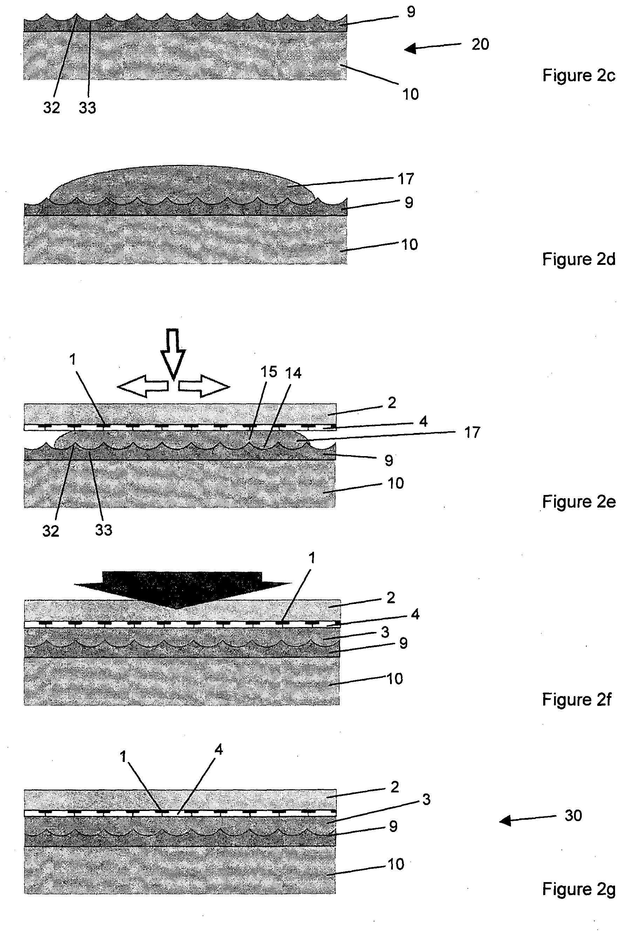

La figure 2 montre de manière schématique un premier procédé selon l'invention pour fabriquer une partie essentielle d'un dispositif selon l'invention, à savoir un module photovoltaïque semi-transparent à réseau lenticulaire.
On approvisionne un substrat **2** sur lequel on a déposé un réseau **8** formé par une pluralité de zones de cellules photovoltaïques **1** et une pluralité d'orifices **7** (figure 2a), appelé « réseau **8** de cellules photovoltaïques **1**». On dépose au-dessus de ce réseau **8** de zones de cellules photovoltaïques **1** un réseau **4** de zones d'images colorées (figure 2b). Ce réseau **4** de zones d'images colorées comprend typiquement trois filtres de couleur différente **4'**, **4"**, **4'"** pour chaque pixel, à savoir un filtre rouge, un filtre bleu et un filtre vert. Ainsi on obtient un premier produit intermédiaire.
Pour déposer le réseau **8** de cellules photovoltaïques **1** sur le substrat **2** on peut employer plusieurs approches et techniques de dépôt ; en particulier on peut déposer les zones de cellules photovoltaïques **1** en cachant les zones libres (orifices) **7** à l'aide d'un masque, et/ou on peut déposer d'abord une ou plusieurs grande(s) zone(s) de cellule(s) photovoltaïque(s) et ensuite dégager les orifices **7** par un procédé de gravure.

De manière indépendante, on approvisionne un premier polariseur **10**, on dépose un polymère sur ledit polariseur **10** et on imprime à ce polymère la texture souhaitée pour le réseau lenticulaire, en utilisant toute technique appropriée, par exemple un tampon ou un rouleau texturé. Cette texture forme une surface lenticulaire. Ledit polymère peut être déposé sous la forme d'une couche liquide, solide ou semi-solide, et il peut être durci après texturisation par toute technique appropriée au polymère utilisé (par exemple par effet thermique ou photochimique).

A titre d'exemple, on peut déposer sur ledit premier polariseur **10** un film plastique partiellement fondu, lui imprimer la texture souhaitée, puis le durcir en le refroidissant. Alternativement on peut déposer sur le premier polariseur **10** un polymère liquide ou semi-liquide à l'aide d'un rouleau texturé et durcir ce film liquide ou semi-liquide. Ainsi on obtient un premier polariseur **10** avec une couche texturée **9** dont la surface lenticulaire présente le négatif de la forme du réseau lenticulaire souhaité (figure 2c). Cette forme en négatif est caractérisée par les sommets **32**, qui représentent les vallées **15** du réseau lenticulaire, et par des vallées **33** qui représentent les sommets **14** du réseau lenticulaire, entre lesquels s'étend la forme de la surface des lentilles individuelles **19**.
Ainsi on obtient un deuxième produit intermédiaire que nous appelons un « polariseur texturé » **20**.
Ledit polymère qui forme ladite couche texturée **9** est avantageusement le même matériau que celui dudit premier polariseur **10**, ou un matériau présentant un indice optique très proche voire identique. Ainsi on évite des pertes optiques par réflexion interne.
Dans une étape suivante on dépose une couche de polymère (colle) optiquement transparente **17** à haut indice de réfraction sur ladite couche texturée **9** (figure 2d); cette couche de colle peut être liquide ou semi-liquide. On pose ledit premier produit intermédiaire sur ladite couche de colle **17** et on ajuste le cas échéant le positionnement respectif des deux composants. Le positionnement du réseau **8** zones de cellules photovoltaïques **1** par rapport aux vallées **15** et sommets **14** du réseau lenticulaire **3** est en effet critique (figure 2e) : pour que les lentilles du réseau lenticulaire **3** puissent focaliser la lumière dans l'orifice **7** entre deux lentilles **1'**,**1"**, les vallées **15** dudit réseau lenticulaire **3** doivent être centrées sur les zones de cellules photovoltaïques **1**, et les sommets **14** sur les orifices **7**. Pour cette raison, l'alignement du polariseur texturé **20** par rapport au substrat **2** doit être tel que les sommets **32** du polariseur texturé **20** sont centrées sur les zones de cellules photovoltaïques **1** et les vallées **33** sur les orifices **7**. Après avoir positionné et aligné correctement les deux composants, on procède à la réticulation de la colle **17** qui forme ainsi le réseau lenticulaire **3** ; la couche texturée **9** agit comme moule pour le réseau lenticulaire **3.** En fonction du choix de la colle **17**, ladite réticulation peut être faite par voie thermique ou, de préférence, par voie photochimique (comme dans la figure 2f), en choisissant une colle **17** photoréticulable. On obtient ainsi un troisième produit intermédiaire (figure 2g) qui présente un réseau lenticulaire **3**. Nous appelons ce troisième produit intermédiaire un « module PV avec réseau lenticulaire et réseau de zones d'image colorées » **30**.

Dans une variante (non illustrée sur les figures) de ce procédé, pour fabriquer le polariseur texturé on ne dépose pas une couche texturée sur le premier polariseur, mais on texturise directement le matériau du premier polariseur, soit par enlèvement de matière, soit par déformation à partir d'un état liquide, semi-liquide ou solide ; c'est alors la surface texturée dudit premier polariseur qui agit comme moule pour le dépôt du réseau lenticulaire à partir dudit polymère optiquement transparent.

Comme montré sur la figure 3, ledit « module PV avec réseau lenticulaire et réseau de zones d'image colorées » **30** (i.e. le produit intermédiaire obtenu par le premier procédé selon l'invention) peut être posé sur un « module d'affichage sans filtres colorés intégrés » **18**, qui sera expliqué ci-dessous, pour obtenir un premier produit (écran d'affichage) **40** selon l'invention. Ce module d'affichage sans filtres colorés intégrés **18** ne comporte pas les zones d'images colorées, qui sont déjà intégrées dans le module PV **30** selon l'invention.

La figure 3 montre schématiquement ledit premier produit **40** selon l'invention en coupe transversale. Il comporte un modulateur électro-optique **5**, par exemple à cristaux liquides, qui peut être rétroéclairé par une source de lumière **6** placée derrière ledit modulateur électro-optique **5**. Cette source de lumière peut être une plaque ou un film, qui peut être éclairé par une ou plusieurs diodes électroluminescentes **12** comme montré sur la figure 3, ou autrement.
Le dispositif **40** selon l'invention comporte par ailleurs un réseau **8** formé par une pluralité de zones de cellules photovoltaïques **1** et une pluralité d'orifices **7**, dans lequel réseau au moins deux zones de cellules photovoltaïques voisines **1'**,**1"** forment un orifice **7**. Ce réseau **8** de zones de cellules photovoltaïques est déposé sur le substrat **2**. Le dispositif **40** comprend par ailleurs un réseau lenticulaire **3** formé par une pluralité de lentilles capables de focaliser, par réfraction, la lumière émise par lesdites zones d'image dans lesdits orifices **7**. Entre le réseau lenticulaire **3** et le réseau **8** de zones de cellules photovoltaïques **1** se trouvent les zones d'images **4**. Entre le réseau lenticulaire **3** et le modulateur électro-optique **5** se trouve le polariseur **10**, appelé ici « premier polariseur », sous la forme d'un film ou d'une plaque. Un autre polariseur **11**, appelé ici «deuxième polariseur », également sous la forme d'un film ou d'une plaque, se trouve entre la source de lumière **6** et le modulateur électro-optique **5**.
Dans un mode de réalisation avantageux, la lumière émise par la source de lumière **6** est collimatée avant d'éclairer le réseau de zones d'images **4**. Cette collimation peut être accomplie à l'aide d'un dispositif de collimation **13** qui peut être à base de couches optiques.
Ainsi, la structure optique du premier dispositif **40** selon l'invention comprend, dans l'ordre et en suivant la direction de la lumière émise :
- une source de lumière **6**, par exemple une plaque dont la lumière peut provenir par exemple d'une ou plusieurs diodes électroluminescentes **12**, qui peuvent éclairer ladite plaque dans sa tranche ;
- optionnellement, un dispositif de collimation **13**, qui peut comporter une pluralité de films individuels ;
- un polariseur dit « deuxième polariseur » **11** ;
- un modulateur électro-optique **5**, notamment à cristaux liquides ;
   (sachant que l'ensemble formé par ladite source de lumière **6**, ledit deuxième polariseur **11** et ledit modulateur électro-optique **5** (ledit dispositif de collimation **13** pouvant s'ajouter optionnellement audit ensemble, comme indiqué), est appelé ici « module d'affichage sans filtres colorés intégrés » **18**),
- un polariseur dit « premier polariseur » **10** ;
- une couche optique texturée **9**, qui présente avantageusement un indice optique (de préférence à au moins ± 0,05 près, et encore plus préférentiellement à au moins ± 0,03 près) voire identique à celui du premier polariseur **10** avec lequel elle est en contact ; cette couche optique texturée **9** n'a pas besoin d'exercer une autre fonction dans ledit dispositif **40**, son rôle est d'agir lors du procédé de fabrication comme moule pour la fabrication du réseau lenticulaire **3** à partir d'un polymère liquide ou semi-liquide (« colle ») **17**, comme décrit ci-dessus ; cette couche optique texturée **9** peut être absente si c'est la surface dudit premier polariseur **10** lui-même qui a été texturé convenablement avec les ondulations du réseau lenticulaire **3** pour pouvoir agir comme moule pour la fabrication du réseau lenticulaire **3** comme décrit ci-dessus ;
- un réseau lenticulaire **3** ;
- un réseau **4** de zones d'images colorées **4'**, **4"**, **4'"** ;
- un réseau de zones de cellules photovoltaïques **1** ;
- un substrat **2** qui protège ledit réseau de zones de cellules photovoltaïques **1**, et sur lequel lesdites zones de cellules photovoltaïques **1** peuvent avoir été déposées lors de leur fabrication.

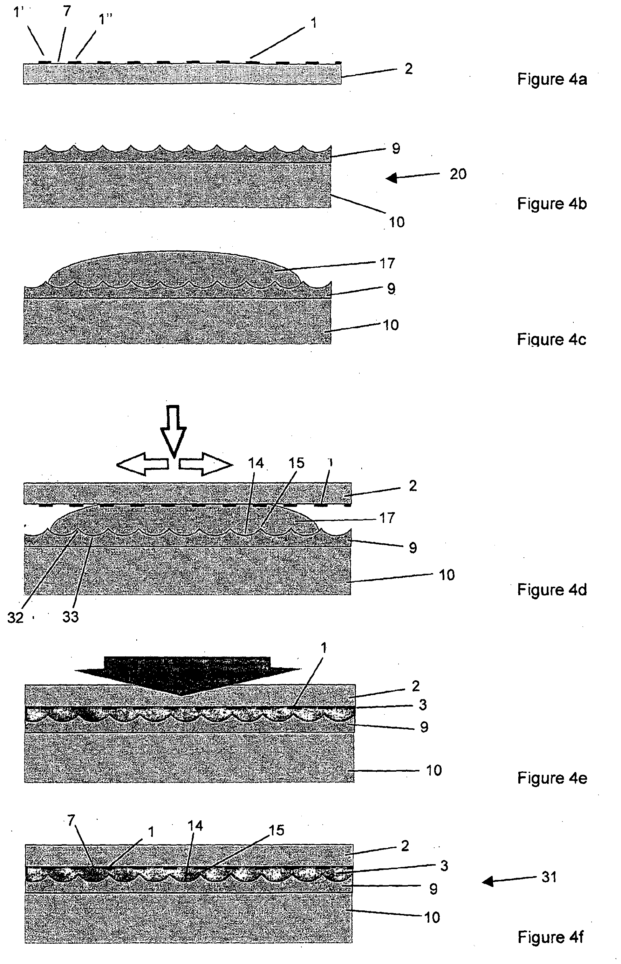

La figure 4 montre un deuxième procédé pour fabriquer une partie essentielle d'un dispositif selon l'invention. Ce procédé utilise comme produit intermédiaire le polariseur texturé **20** de la figure 2c, qui est montré à l'identique sur la figure 4b. Comme dans le cas du premier procédé, et à titre de variante (non illustrée sur les figures) de ce procédé, on pourrait aussi utiliser un premier polariseur **10** dont le matériau a été texturé au lieu de déposer une couche optique texturée **9** pour fabriquer le polariseur texturé **20** ; cette texture du premier polariseur **10** peut être obtenue soit par enlèvement de matière, soit par déformation à partir d'un état liquide, semi-liquide ou solide ; c'est alors la surface texturée dudit premier polariseur **10** qui agit comme moule pour le dépôt du réseau lenticulaire **3** à partir dudit polymère optiquement transparent **17**.

Dans ce deuxième procédé, on approvisionne un substrat **2** sur lequel on a déposé un réseau de zones de cellules photovoltaïques **1** (figure 4a). De manière indépendante, on approvisionne ledit polariseur texturé **20**. On dépose une couche de polymère (colle) optiquement transparente **17** à haut indice de réfraction sur la surface texturée dudit polariseur texturé **20** (figure 4c), cette surface texturée étant soit la face texturée du polariseur soit la face texturée de ladite couche texturée **9**.
On pose ledit substrat **2** avec le réseau de zones de cellules photovoltaïques **1** sur ladite couche de colle **17** et on ajuste le cas échéant le positionnement respectif des deux composants. Le positionnement des zones de cellules photovoltaïques **1** par rapport aux vallées **15** et sommets **14** du réseau lenticulaire est en effet critique (figure 4d) : pour que les lentilles du réseau lenticulaire **3** puissent focaliser la lumière dans l'orifice **7** entre deux lentilles **1'**,**1"**, les vallées **15** dudit réseau lenticulaire **3** doivent être centrées sur les zones de cellules photovoltaïques **1**, et les sommets **14** sur les orifices **7**. Pour cette raison, l'alignement du polariseur texturé **20** par rapport au substrat **2** doit être tel que les sommets **32** du polariseur texturé **20** sont centrées sur les zones de cellules photovoltaïques **1** et les vallées **33** sur les orifices **7**. Après avoir positionné et aligné correctement les deux composants, on procède à la réticulation de la colle **17** qui forme ainsi le réseau lenticulaire **3** ; la couche texturée **9** agit comme moule pour le réseau lenticulaire **3**. En fonction du choix de la colle **17**, ladite réticulation peut être faite par voie thermique ou, de préférence, par voie photochimique (comme dans la figure 4e), en choisissant une colle **17** photoréticulable. On obtient ainsi un quatrième produit intermédiaire (figure 4f) qui présente un réseau lenticulaire **3**. Nous appelons ce quatrième produit intermédiaire un « module PV avec réseau lenticulaire sans réseau de zones d'image colorées » **31**.

Comme montré sur la figure 5, ledit polariseur lenticulaire sans filtres couleur **31** obtenu par le deuxième procédé selon l'invention peut être posé sur un « module d'affichage avec filtres colorés intégrés » **22**, qui sera expliqué ci-dessous, pour obtenir un deuxième produit selon l'invention, de manière à ce que le premier polariseur **10** se trouve en aval dudit dispositif d'affichage (les termes directionnels «en amont» et «en aval» se réfèrent à la direction de la lumière qui va de la source de lumière vers l'utilisateur du dispositif **41** situé en aval de la source de lumière). Si ledit module d'affichage avec filtres colorés intégrés **22** comporte un réseau **4** de filtres colorés, ce dernier se trouve entre le modulateur électro-optique **5** et le premier polariseur **10**. Ce réseau **4** de zones d'images colorées comprend typiquement trois zones **4'**, **4"**, **4'"** pour chaque pixel, à savoir une zone rouge, une zone bleue et une zone verte.

La figure 5 montre schématiquement un deuxième dispositif d'affichage **41** selon l'invention en coupe transversale. Il comporte un modulateur électro-optique **5**, notamment à cristaux liquides, pourvu en aval de zones d'images colorées **4'**,**4"**,**4"'**rétroéclairées par une source de lumière **6** placée en amont dudit modulateur électro-optique **5**. Cette source de lumière **6** peut être une plaque ou un film, qui peut être éclairé par une ou plusieurs diodes électroluminescentes **12** comme montré sur la figure 5, ou autrement.
Ce dispositif **41**. selon l'invention comporte par ailleurs un réseau **8** formé par une pluralité de zones de cellules photovoltaïques **1** et une pluralité d'orifices **7**, dans lequel réseau au moins deux zones de cellules photovoltaïques voisines **1'**,**1"** forment un orifice **7**. Ce réseau **8** de zones de cellules photovoltaïques est déposé sur un substrat **2**. Le dispositif **41** comprend par ailleurs un réseau lenticulaire **3** formé par une pluralité de lentilles capables de focaliser, par réfraction, la lumière émise par lesdites zones d'image dans lesdits orifices **7**. Ledit réseau lenticulaire **3** est en contact optique avec le réseau **8** de zones de cellules photovoltaïques 1**.** Entre le réseau lenticulaire **3** et les zones d'images **4** se trouve le polariseur **10**, appelé ici « premier polariseur », sous la forme d'un film ou d'une plaque. Un autre polariseur **11**, appelé ici « deuxième polariseur », également sous la forme d'un film ou d'une plaque, se trouve entre la source de lumière **6** et le modulateur électro-optique **5**, et de préférence en contact optique avec le modulateur électro-optique **5**.

Le terme « contact optique » entre deux milieux au moins partiellement transparents signifie ici un contact sans gap d'air, de manière à ce que le faisceau de lumière qui traverse l'interface entre les deux milieux ne rencontre qu'une seule interface.

Dans un mode de réalisation avantageux de ce deuxième mode de réalisation, la lumière émise par la source de lumière **6** est collimatée avant d'éclairer les zones d'images **4**. Cette collimation peut être accomplie à l'aide d'un dispositif de collimation **13**.
Ainsi, la structure optique du dispositif **41** selon l'invention comprend, dans l'ordre et en suivant la direction de la lumière émise :
- une source de lumière **6**, par exemple une plaque dont la lumière peut provenir par exemple d'une ou plusieurs diodes électroluminescentes **12**, qui peuvent éclairer ladite plaque dans sa tranche ;
- un dispositif de collimation **13**, qui peut comporter une pluralité de films individuels ;
- un polariseur dit « deuxième polariseur » **11** ;
- un modulateur électro-optique **5** ;
- un réseau de zones d'images colorées **4**;
   (sachant que l'ensemble formé par ladite source de lumière **6**, ledit deuxième polariseur **11**, ledit modulateur électro-optique **5** et ledit réseau **4** de zones d'images colorées (ledit dispositif de collimation **13** pouvant s'ajouter optionnellement audit ensemble, comme indiqué), est appelé ici « module d'affichage avec filtres colorés intégrés » **22**),
- un polariseur dit « premier polariseur » **10** ;
- une couche optique **9** texturée avec les ondulations du réseau lenticulaire **3**, ladite couche **9** présente avantageusement un indice optique proche voire identique à celui du premier polariseur **10** avec lequel elle est en contact; cette couche optique texturée **9** n'a pas besoin d'exercer une autre fonction dans ledit dispositif **41**, son rôle est d'agir lors du procédé de fabrication comme moule pour la fabrication du réseau lenticulaire **3** à partir d'un polymère liquide ou semi-liquide («colle») **17**, comme décrit ci-dessus ; cette couche optique texturée **9** peut être absente si c'est la surface du premier polariseur **10** lui-même qui a été texturée convenablement avec les ondulations du réseau lenticulaire pour pouvoir agir comme moule pour la fabrication du réseau lenticulaire **3** comme décrit ci-dessus ;
- un réseau lenticulaire **3** ;
- un réseau de zones de cellules photovoltaïques **1** ;
- un substrat **2** qui protège ledit réseau de zones de cellules photovoltaïques **1**, et sur lequel lesdites zones de cellules photovoltaïques **1** peuvent avoir été déposées lors de leur fabrication.

Pour les deux produits **30**,**31** selon l'invention :
- Les zones d'images colorées **4'**,**4"**,**4'"** émettent ou transmettent une lumière de la couleur souhaitée ; cette couleur peut être générée notamment par émission, par absorption ou par interférence, sachant que dans un dispositif d'affichage couleur, un pixel comprend typiquement trois zones de couleur (bleu, rouge, vert). Lesdites zones d'images colorées peuvent être des filtres colorés. Elles peuvent également mettre en oeuvre la technologie des boîtes quantiques («quantum dot» en anglais), ou toute autre technologie appropriée.
- Le substrat des cellules photovoltaïques **2** peut être en verre, en plastique ou en tout autre matériau transparent ; il peut être plat ou non, par exemple galbé ou courbé, il peut avoir n'importe quelle forme, notamment rectangulaire, avec coins arrondis ou non.
- Le réseau de zones de cellules photovoltaïques **8** peut comprendre des bandes de cellules photovoltaïques. Ces dernières peuvent par exemple être parallèles, et dans ce cas les orifices **7** ont également la forme de bandes, appelées « bandes libres » ; elles peuvent être disposées autrement que parallèles, par exemple formant un réseau hexagonal.
- Le réseau lenticulaire **3** est typiquement en matière plastique (polymère) optiquement transparent. Il peut être constitué d'une juxtaposition de lentilles rectilignes ou autres, identiques ou différentes, qui peuvent être de type plan-convexe ou biconvexe, ou autre ; elles peuvent être de type symétrique ou asymétrique, sphérique ou asphérique. Avantageusement, ledit réseau lenticulaire **3** génère un effet de lentille individuelle pour chaque pixel, focalisant la lumière provenant du module d'affichage **18**,**22** dans l'orifice (bande libre) **7** entre deux zones ou bandes photovoltaïques **1'**,**1"** voisines. Dans une variante, chaque unité de couleur du pixel (par exemple chaque zone d'image colorée **4'**,**4"**,**4"'**) dispose de sa propre lentille. Dans le cas où les zones de cellules photovoltaïques sont des bandes **1**, il est avantageux que le réseau lenticulaire **3** soit composé de bandes de lentilles, ces bandes de lentilles étant parallèles aux bandes libres dans lesquelles elles doivent focaliser la lumière en provenance du dispositif d'affichage **5**.
- Les premier et deuxième polariseurs **10**,**11** peuvent mettre en oeuvre toute technologie appropriée, par exemple il peut s'agir de films polymères orientés, ou encore de films comportant des grilles (ces grilles pouvant comporter des fils métalliques parallèles et/ou des bandes parallèles déposée par un procédé microlithographique ou autre).
- Le dispositif de collimation **13**, qui est optionnel, peut comprendre des grilles de guide d'ondes aptes à diriger la lumière dans un segment de l'espace caractérisé par un angle de sortie étroit. Il peut s'agir par exemple d'un film de type CMOF (Collimating Multilayer Optical Film) commercialisé par la société 3M. Il peut s'agir également d'un dispositif à guide d'ondes tel que décrit dans la demande de brevet WO 2005/107363 (Oy Modilis Ltd.), ou d'un film à cavités optiques comme celui décrit dans le document WO 2011/127187 (Mobilis Holding LLC), comprenant une pluralité de cavités optiques agissant comme guide d'ondes ; ces cavités peuvent être notamment des cavités prismatiques. De tels dispositifs de collimation peuvent être fabriqués par laminage d'un film polymère avec un rouleau convenablement texturé qui imprime la structure en cavités au film polymère. Ledit film polymère peut notamment être solide, liquide ou semi-liquide ; il peut être recouvert d'un film protecteur.

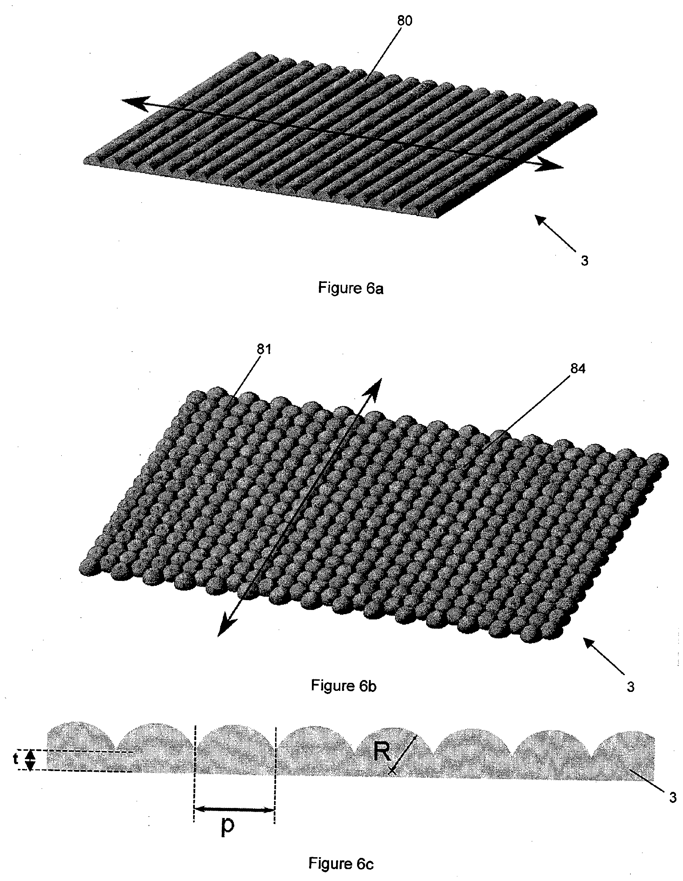

Dans tous les modes de réalisation de l'invention, et comme cela est montré sur la figure 6, ledit réseau lenticulaire **3** peut être constitué d'une pluralité de bandes lenticulaires **80** comportant des lentilles rectilignes cylindriques (figure 6a), ou d'une pluralité de bandes lenticulaires **81** de lentilles sphériques hexagonales **82** (figure 6b). Les paramètres géométriques du réseau lenticulaire **3** vu selon les deux plans de coupe matérialisés sur les figures 6a et 6b sont indiqués sur la figure 6c.
La figure 7 définit des paramètres géométriques du réseau lenticulaire selon deux modes de réalisation particuliers. La figure 7a représente la surface du réseau de cellules photovoltaïques dans un mode de réalisation où les zones de cellules photovoltaïques forment un réseau de bandes parallèles **1** de largeur CD, deux bandes voisines **1'**, **1"** délimitant une bande libre **7**. La figure 7b montre un mode de réalisation avec des orifices hexagonaux **84** les cellules photovoltaïques **85** ont la forme de bandes de largeur CD formant un réseau hexagonal : chaque segment droit d'une bande de cellules photovoltaïques délimite deux zones hexagonales voisines **84'**,**84"**, ou (aux points de contact **86**) trois zones hexagonales voisines **84'**,**84"**,**84'"** ; ainsi le réseau de bandes photovoltaïques **85** délimite le réseau des orifices **84**. La figure 7c montre le réseau de cellules photovoltaïques **1** associé au réseau lenticulaire **3** vu selon les deux plans de coupe matérialisés sur les figures 7a et 7b. Selon le dispositif représenté sur la figure 7c, p est avantageusement compris entre 5 µm et 100 µm et CD est avantageusement compris entre 0,1 p et 0,9 p. R est avantageusement compris entre 0,5 p et p dans le mode de réalisation de la figure 7a, et entre 0,57 p et p dans le mode de réalisation de la figure 7b.

A titre d'exemple, on a réalisé des dispositifs selon l'invention telle que représentée sur la figure 7a avec p = 50 µm, t = 10 µm et avec un rayon de courbure R = 26 µm. On a également réalisé des dispositifs avec p = 30 µm, t = 6 µm et R = 16 µm, le paramètre t étant défini sur la figure 6c.

On a également réalisé des dispositifs selon l'invention telle que représentée sur la figure 7b avec a = 25 µm, d = 50 µm, t = 10 µm, h = 43,3 µm et R = 26 µm. Un autre exemple avait les paramètres suivants : a = 15 µm, d = 30 µm, t = 6 µm, h = 26 µm et R = 16 µm, le paramètre t étant défini sur la figure 6c.

La figure 8 montre schématiquement un troisième dispositif d'affichage 42 selon l'invention en coupe transversale. Il comporte un modulateur électro-optique **5**, notamment à cristaux liquides, pourvu en aval de zones d'images colorées **4'**,**4"**,**4"'**rétroéclairées par une source de lumière **6** placée en amont dudit modulateur électro-optique **5**. Cette source de lumière **6** peut être une plaque ou un film, qui peut être éclairé par une ou plusieurs diodes électroluminescentes **12** comme montré sur la figure 8, ou autrement.
Ce dispositif **42** selon l'invention comporte par ailleurs un réseau 8 formé par une pluralité de zones de cellules photovoltaïques **1** et une pluralité d'orifices **7**, dans lequel réseau au moins deux zones de cellules photovoltaïques voisines **1'**,**1"** forment un orifice **7**. Ce réseau **8** de zones de cellules photovoltaïques est déposé sur un substrat **2**. Le dispositif **42** comprend par ailleurs un réseau de concentrateurs optiques **3** formé par une pluralité de concentrateurs paraboliques capables de focaliser, par réflexion, la lumière émise par lesdites zones d'image **4** dans lesdits orifices **7**. Cette réflexion peut avoir lieu à l'interface entre deux milieux optiques **3**,**9** d'indices de réfraction différents, ou bien sur une surface réfléchissante, le concentrateur optique **3** étant alors recouvert d'une surface réfléchissante ou composé intégralement d'un matériau réfléchissant, par exemple métallique. La figure 8 montre un concentrateur de forme parabolique qui convient à la réalisation de la présente invention, mais il existe de nombreuses autres formes permettant de concentrer par réflexion la lumière émise par les zones d'images **4**. Avantageusement, à chaque concentrateur optique correspond une zone d'image colorée **4'**,**4"**,**4"'** individuelle ou un groupe de trois zones d'images **4'**,**4"**,**4"'** formant un pixel. Ledit réseau de concentrateurs optiques **3** est en contact avec le réseau **8** de zones de cellules photovoltaïques **1**. Entre le réseau de concentrateurs optiques **3** et les zones d'images **4** se trouve le polariseur **10**, appelé ici « premier polariseur », sous la forme d'un film ou d'une plaque. Un autre polariseur **11**, appelé ici «deuxième polariseur », également sous la forme d'un film ou d'une plaque, se trouve entre la source de lumière **6** et le modulateur électro-optique **5**, et de préférence en contact optique avec le modulateur électro-optique **5**.

L'écran digital d'affichage **40**,**41**,**42** selon l'invention peut être incorporé dans un appareil électronique fixe ou portable ; cet appareil forme un autre objet de l'invention. Il peut s'agir en particulier d'un téléphone portable, d'un livre électronique, d'un écran de télévision portable, d'un écran d'ordinateur portable. Il peut s'agir également d'appareils fixes de taille plus importante, par exemple d'un écran de télévision fixe ou d'affichage publicitaire. L'écran digital d'affichage **40**,**41**,**42** selon l'invention peut comporter un film ou un revêtement tactile, c'est-à-dire sensible au toucher, de manière à obtenir un écran tactile.

Dans tous les modes de réalisation de l'invention, les cellules photovoltaïques **1** peuvent utiliser toute technologie en couches minces connue et appropriée. Pour des écrans destinés aux dispositifs utilisés à l'intérieur, il est préférable d'utiliser des cellules qui ont une bonne efficacité de conversion à faible luminosité (par exemple des cellules à base de silicium amorphe ou microcristallin), car lesdites cellules capteront principalement de la lumière diffusante.
Dans tous les modes de réalisation de l'invention, le dispositif d'affichage **40**,**41**,**42** selon l'invention peut comprendre d'autres composants qui améliorent ses caractéristiques ou qui les adaptent à certaines situations d'utilisation particulières. A titre d'exemple, il peut comprendre également un ou plusieurs des éléments suivants : un filtre de couleur, un filtre de polarisation, un élément lenticulaire, un diffuseur de lumière, une couche protectrice, une couche antireflet. Le dispositif d'affichage **40**,**41**,**42** peut aussi être un écran souple.

D'une manière générale, la présente description ne mentionne pas le positionnement et le dépôt des contacts électriques et connexions électriques pour récupérer l'énergie électrique produite par les cellules PV. L'homme du métier effectuera aisément ces connexions en mettant en oeuvre ses connaissances techniques générales.

### Avantages de l'invention

L'invention présente de nombreux avantages. Elle réduit le temps requis par le procédé de fabrication du module PV tout en fiabilisant sa qualité. En effet, on économise l'étape de démoulage du réseau lenticulaire, qui est une étape qui présente un taux de rebut significatif. On économise également une étape d'encollage et éventuellement une étape de traitement de surface du moule.

Le dispositif d'affichage **40** de la présente invention réduit par ailleurs l'épaisseur totale du dispositif, qui est déterminée par l'épaisseur des feuilles de verre présentes dans le dispositif, par rapport aux dispositifs d'affichage selon l'état de la technique. En effet, dans les dispositifs d'affichage selon l'état de la technique, les zones d'images colorées sont généralement déposées sur un substrat spécifique (typiquement une feuille de verre). Dans le dispositif d'affichage **40**, on s'affranchit de ce substrat supplémentaire en déposant directement les zones d'images colorées sur le substrat du réseau PV. Outre l'épaisseur, la multiplication des feuilles de verre dans le dispositif augmente son coût de revient, le verre en feuille mince étant un produit coûteux. L'invention permet donc de réduire le coût de fabrication du dispositif d'affichage **40.**

**Liste des repères utilisés sur les figures :**

| | | | |
|---|---|---|---|
| 1 | Zones de cellules photovoltaïques (PV) | 22 | Module d'affichage avec filtres colorés intégrés |
| 2 | Substrat des cellules PV | 23 | Ondulation |
| 3 | Réseau lenticulaire | 30 | Module PV semi-transparent avec réseau lenticulaire et réseau de zones d'image colorées |
| 4 | Réseau de zones d'images colorées | | |
| 5 | Modulateur électro-optique | | |
| 6 | Source de lumière (rétroéclairage) | 31 | Module PV semi-transparent avec réseau lenticulaire sans réseau de zones d'image colorées |
| 7 | Orifice entre zones de cellules PV | | |
| 8 | Réseau de zones de cellules PV | | |
| 9 | Couche optique texturée | 32 | Sommets du polariseur texturé |
| 10 | Premier polariseur | 33 | Vallées du polariseur texturé |
| 11 | Deuxième polariseur | 40 | Dispositif d'affichage selon l'invention |
| 12 | Diode électroluminescente | | |
| 13 | Dispositif de collimation | 41 | Dispositif d'affichage selon l'invention |
| 14 | Sommets du réseau lenticulaire | | |
| 15 | Vallées du réseau lenticulaire | 80 | Bande lenticulaire |
| 16 | Dispositif d'affichage | 81 | Bande lenticulaire |
| 17 | Colle pour réseau lenticulaire | 82 | Lentille hexagonale sphérique |
| 18 | Module d'affichage sans filtres colorés intégrés | 84 | Bande libre (orifice) |
| 19 | Lentille du réseau lenticulaire | 85 | Zone de cellules photovoltaïques |
| 20 | Polariseur texturé | 86 | Point triple |
| 21 | Espace | | |

## Revendications

1. Procédé de fabrication d'un module photovoltaïque disposé sur un dispositif d'affichage émissif, ledit module photovoltaïque comportant un réseau (8) présentant une pluralité de zones de cellules photovoltaïques (1) et une pluralité de zones transparentes dites « orifices » (7) entre les zones de cellules photovoltaïques (1), et ledit module photovoltaïque comportant un réseau d'éléments optiques (3) en polymère aptes à focaliser, par réfraction ou par réflexion, la lumière émise par le dispositif d'affichage dans les orifices (7), dans lequel procédé :
- on approvisionne un substrat (2) sur lequel on a déposé le réseau (8) présentant une pluralité de zones de cellules photovoltaïques (1) et une pluralité d'orifices (7) ;
- on approvisionne un polariseur texturé (20) comportant une surface texturée composée d'un réseau de sommets (32) et des vallées (33) qui représentent la forme négative dudit réseau d'éléments optiques (3), de manière à ce que les vallées (15) dudit réseau d'éléments optiques (3) sont représentées sur ladite surface texturée dudit polariseur texturé (20) par des sommets (32) et les sommets (14) dudit réseau d'éléments optiques (3) par des vallées (33) de la surface du polariseur texturé ;
- on fixe la face texturée dudit polariseur texturé (20) sur la face dudit substrat (2) qui comporte lesdites cellules photovoltaïques (1), à l'aide d'un polymère (17) transparent liquide ou semi-liquide, le positionnement respectif dudit polariseur texturé (20) et dudit substrat (2) étant tel que les sommets (32) ou les vallées (33) dudit polariseur texturé (20) sont alignés sur le centre desdites zones de cellules photovoltaïques (1) ou sur le centre desdits orifices (7) ;
- on procède à la réticulation dudit polymère (17) pour obtenir une liaison entre ledit polariseur texturé (10) et ledit substrat (2) comportant des zones de cellules photovoltaïques (1).

2. Procédé selon la revendication 1, dans lequel ledit réseau (8) de cellules photovoltaïques (1) est au moins partiellement recouvert d'un réseau (4) de zones colorées (4',4",4"').

3. Procédé selon les revendications 1 ou 2, dans lequel on fabrique ledit polariseur texturé (20) par un procédé dans lequel :
- on approvisionne un premier polariseur (10) ;
- on dépose sur l'une de ses surfaces un polymère liquide ou semi-liquide ;
- on imprime à ce polymère la texture souhaitée pour obtenir ladite surface texturée, par exemple à l'aide d'un rouleau ou d'un tampon texturé ;
- on procède à la réticulation dudit polymère ;
sachant que ledit polymère, après réticulation, doit être optiquement transparent.

4. Procédé selon la revendication 3, dans lequel ledit polymère est le même matériau que celui dudit premier polariseur (10).

5. Procédé selon les revendications 1 ou 2, dans lequel on fabrique ledit polariseur texturé (20) par un procédé dans lequel :
- on approvisionne un premier polariseur (10) ;
- on imprime à l'une de ses surfaces la texture souhaitée pour obtenir ladite surface texturée, par exemple à l'aide d'un rouleau ou d'un tampon texturé.

6. Dispositif d'affichage avec cellules photovoltaïques (1) et concentrateurs de lumière (3) intégrés obtenu par le procédé selon l'une quelconque des revendications 1 à 5, **caractérisé en ce qu'**il comprend, dans l'ordre et en suivant la direction de la lumière émise :
- une source de lumière (6), telle qu'une plaque lumineuse ;
- optionnellement un dispositif de collimation (13), qui peut comporter une pluralité de films individuels ;
- un polariseur (11) dit « deuxième polariseur » ;
- un modulateur électro-optique (5) ;
- un polariseur dit « premier polariseur » (10) ;
- une couche optique texturée (9) en contact avec le premier polariseur (10), qui présente avantageusement un indice optique identique à celui du premier polariseur (10) ou différent de celui-ci de moins de ± 0,05;
- un réseau de concentrateurs optiques (3) aptes à focaliser la lumière (6) dans des orifices (7);
- un réseau (4) de zones d'images colorées ;
- un réseau (8) de zones de cellules photovoltaïques et de zones transparentes dites «orifices» (7) entre les zones de cellules photovoltaïques (1);
- un substrat (2) qui protège ledit réseau de zones (8) de cellules photovoltaïques, et sur lequel lesdites zones de cellules photovoltaïques peuvent avoir été déposées lors de leur fabrication.

7. Dispositif d'affichage avec cellules photovoltaïques (1) et concentrateurs de lumière (3) intégrés obtenu par le procédé selon l'une quelconque des revendications 1 à 5, **caractérisé en ce qu'**il comprend, dans l'ordre et en suivant la direction de la lumière émise :
- une source de lumière (6), telle qu'une plaque lumineuse ;
- optionnellement un dispositif de collimation (13), qui peut comporter une pluralité de films individuels ;
- un polariseur (11) dit « deuxième polariseur » ;
- un modulateur électro-optique (5) ;
- un réseau (4) de zones d'images colorées ;
- un polariseur dit « premier polariseur » (10) ;
- une couche optique texturée (9) en contact avec le premier polariseur (10), qui présente avantageusement un indice optique identique à celui du premier polariseur (10) ou différent de celui-ci de moins de ± 0,05;
- un réseau de concentrateurs optiques (3) aptes à focaliser la lumière (6) dans des orifices (7);
- un réseau (8) de zones de cellules photovoltaïques et de zones transparentes dites «orifices» (7) entre les zones de cellules photovoltaïques (1) ;
- un substrat (2) qui protège ledit réseau de zones (8) de cellules photovoltaïques, et sur lequel lesdites zones de cellules photovoltaïques peuvent avoir été déposées lors de leur fabrication.

8. Dispositif d'affichage selon la revendication 6 ou 7, **caractérisé en ce que** lesdits concentrateurs optiques sont constitués d'une ou plusieurs surfaces planes, concaves ou convexes, et de formes paraboliques, coniques, pyramidales, tétraédriques, demi-cylindriques ou cylindro-paraboliques.

9. Appareil électronique fixe ou portable, **caractérisé en ce qu'**il comprend un dispositif d'affichage selon l'une quelconque des revendications 6 à 8.

## Patentansprüche

1. Verfahren zur Herstellung eines Photovoltaikmoduls, das auf einer emittierenden Anzeigevorrichtung angeordnet ist, wobei das Photovoltaikmodul ein Gitter (8) aufweist, das mehrere Bereiche von Photovoltaikzellen (1) und mehrere durchsichtige Bereiche (7), "Öffnungen" genannt, zwischen den Bereichen von Photovoltaikzellen (1) aufweist, und wobei das Photovoltaikmodul ein Gitter von optischen Elementen (3) aus Polymer aufweist, die in der Lage sind, durch Brechung oder durch Reflexion das von der Anzeigevorrichtung emittierte Licht in den Öffnungen (7) zu fokussieren, wobei bei diesem Verfahren:
- ein Substrat (2) bereitgestellt wird, auf welches das Gitter (8) aufgebracht worden ist, das mehrere Bereiche von Photovoltaikzellen (1) und mehrere Öffnungen (7) aufweist;
- ein strukturierter Polarisator (20) bereitgestellt wird, der eine strukturierte Fläche aufweist, die aus einem Gitter von Spitzen (32) und von Tälern (33) besteht, welche die negative Form des Gitters von optischen Elementen (3) darstellen, derart, dass die Täler (15) des Gitters von optischen Elementen (3) auf der strukturierten Fläche des strukturierten Polarisators (20) durch Spitzen (32) und die Spitzen (14) des Gitters von optischen Elementen (3) durch Täler (33) der Fläche des strukturierten Polarisators repräsentiert werden;
- die strukturierte Seite des strukturierten Polarisators (20) auf der Seite des Substrats (2), welche die Photovoltaikzellen (1) aufweist, mithilfe eines flüssigen oder halbflüssigen durchsichtigen Polymers (17) befestigt wird, wobei die jeweilige Positionierung des strukturierten Polarisators (20) und des Substrats (2) so erfolgt, dass die Spitzen (32) oder die Täler (33) des strukturierten Polarisators (20) auf den Mittelpunkt der Bereiche von Photovoltaikzellen (1) oder auf den Mittelpunkt der Öffnungen (7) ausgerichtet sind;
- die Vernetzung des Polymers (17) durchgeführt wird, um eine Verbindung zwischen dem strukturierten Polarisator (10) und dem Substrat (2), das Bereiche von Photovoltaikzellen (1) aufweist, zu bewirken.

2. Verfahren nach Anspruch 1, wobei das Gitter (8) von Photovoltaikzellen (1) wenigstens teilweise von einem Gitter (4) von farbigen Bereichen (4□, 4□, 4□□□) bedeckt wird.

3. Verfahren nach den Ansprüchen 1 oder 2, wobei der strukturierte Polarisator (20) durch ein Verfahren hergestellt wird, bei welchem:
- ein erster Polarisator (10) bereitgestellt wird;
- auf eine seiner Flächen ein flüssiges oder halbflüssiges Polymer aufgebracht wird;
- auf dieses Polymer die gewünschte Struktur zum Beispiel mithilfe einer strukturierten Walze oder eines strukturierten Stempels gedruckt wird, um die strukturierte Fläche zu erhalten;
- die Vernetzung des Polymers durchgeführt wird;
unter Beachtung dessen, dass das Polymer nach der Vernetzung optisch transparent sein muss.

4. Verfahren nach Anspruch 3, wobei das Polymer dasselbe Material ist wie dasjenige des ersten Polarisators (10).

5. Verfahren nach den Ansprüchen 1 oder 2, wobei der strukturierte Polarisator (20) durch ein Verfahren hergestellt wird, bei welchem:
- ein erster Polarisator (10) bereitgestellt wird;
- auf eine seiner Flächen die gewünschte Struktur zum Beispiel mithilfe einer strukturierten Walze oder eines strukturierten Stempels gedruckt wird, um die strukturierte Fläche zu erhalten.

6. Anzeigevorrichtung mit Photovoltaikzellen (1) und integrierten Lichtkonzentratoren (3), welche durch das Verfahren nach einem der Ansprüche 1 bis 5 erhalten wurde, **dadurch gekennzeichnet, dass** sie in der Reihenfolge und entlang der Richtung des emittierten Lichtes umfasst:
- eine Lichtquelle (6), wie etwa eine Leuchtplatte;
- optional eine Kollimationsvorrichtung (13), welche mehrere einzelne Filme aufweisen kann;
- einen Polarisator (11), "zweiter Polarisator" genannt;
- einen elektrooptischen Modulator (5);
- einen Polarisator, "erster Polarisator" (10) genannt;
- eine mit dem ersten Polarisator (10) in Kontakt stehende strukturierte optische Schicht (9), welche vorteilhafterweise einen Brechungsindex aufweist, der mit demjenigen des ersten Polarisators (10) identisch ist oder sich von diesem um weniger als □ 0,05 unterscheidet;
- ein Gitter von optischen Konzentratoren (3), die in der Lage sind, das Licht (6) in Öffnungen (7) zu fokussieren;
- ein Gitter (4) von farbigen Bildbereichen;
- ein Gitter (8) von Bereichen von Photovoltaikzellen und von "Öffnungen" genannten durchsichtigen Bereichen (7) zwischen den Bereichen von Photovoltaikzellen (1);
- ein Substrat (2), welches das Gitter von Bereichen (8) von Photovoltaikzellen schützt und auf welches die Bereiche von Photovoltaikzellen bei ihrer Herstellung aufgebracht worden sein können.

7. Anzeigevorrichtung mit Photovoltaikzellen (1) und integrierten Lichtkonzentratoren (3), welche durch das Verfahren nach einem der Ansprüche 1 bis 5 erhalten wurde, **dadurch gekennzeichnet, dass** sie in der Reihenfolge und entlang der Richtung des emittierten Lichtes umfasst:
- eine Lichtquelle (6), wie etwa eine Leuchtplatte;
- optional eine Kollimationsvorrichtung (13), welche mehrere einzelne Filme aufweisen kann;
- einen Polarisator (11), "zweiter Polarisator" genannt;
- einen elektrooptischen Modulator (5);
- ein Gitter (4) von farbigen Bildbereichen;
- einen Polarisator, "erster Polarisator" (10) genannt;
- eine mit dem ersten Polarisator (10) in Kontakt stehende strukturierte optische Schicht (9), welche vorteilhafterweise einen Brechungsindex aufweist, der mit demjenigen des ersten Polarisators (10) identisch ist oder sich von diesem um weniger als □ 0,05 unterscheidet;
- ein Gitter von optischen Konzentratoren (3), die in der Lage sind, das Licht (6) in Öffnungen (7) zu fokussieren;
- ein Gitter (8) von Bereichen von Photovoltaikzellen und von "Öffnungen" genannten durchsichtigen Bereichen (7) zwischen den Bereichen von Photovoltaikzellen (1);
- ein Substrat (2), welches das Gitter von Bereichen (8) von Photovoltaikzellen schützt und auf welches die Bereiche von Photovoltaikzellen bei ihrer Herstellung aufgebracht worden sein können.

8. Anzeigevorrichtung nach Anspruch 6 oder 7, **dadurch gekennzeichnet, dass** die optischen Konzentratoren aus einer oder mehreren ebenen, konkaven oder konvexen Flächen und aus parabolischen, konischen, pyramidalen, tetraedrischen, halbzylindrischen oder zylindrisch-parabolischen Formen bestehen.

9. Festes oder tragbares elektronisches Gerät, **dadurch gekennzeichnet, dass** es eine Anzeigevorrichtung nach einem der Ansprüche 6 bis 8 umfasst.

## Claims

1. Method of fabricating a photovoltaic module disposed on an emissive display device, said photovoltaic module comprising an array (8) exhibiting a plurality of zones of photovoltaic cells (1) and a plurality of transparent zones termed "orifices" (7) between the zones of photovoltaic cells (1), and said photovoltaic module comprising an array of optical elements (3) made of polymer able to focus, by refraction or by reflection, the light emitted by the display device display in the orifices (7), in which method:
- a substrate (2) is supplied, on which has been deposited the array (8) exhibiting a plurality of zones of photovoltaic cells (1) and a plurality of orifices (7);
- a textured polarizer (20) is supplied, comprising a textured surface composed of an array of crests (32) and of troughs (33) which represent the negative shape of said array of optical elements (3), in such a way that the troughs (15) of said array of optical elements (3) are represented on said textured surface of said textured polarizer (20) by crests (32) and the crests (14) of said array of optical elements (3) by troughs (33) of the surface of the textured polarizer;
- the textured face of said textured polarizer (20) is fixed on the face of said substrate (2) which comprises said photovoltaic cells (1), with the aid of a liquid or semi-liquid transparent polymer (17), the respective positioning of said textured polarizer (20) and of said substrate (2) being such that the crests (32) or the troughs (33) of said textured polarizer (20) are aligned with the centre of said zones of photovoltaic cells (1) or with the centre of said orifices (7);
- the crosslinking of said polymer (17) is undertaken so as to obtain a bond between said textured polarizer (10) and said substrate (2) comprising zones of photovoltaic cells (1).

2. Method according to Claim 1, in which said array (8) of photovoltaic cells (1) is at least partially covered with an array (4) of coloured zones (4',4",4"').

3. Method according to Claims 1 or 2, in which said textured polarizer (20) is fabricated by a method in which:
- a first polarizer (10) is supplied;
- a liquid or semi-liquid polymer is deposited on one of its surfaces;
- the desired texture is imparted to this polymer so as to obtain said textured surface, for example with the aid of a textured pad or a roll;
- the crosslinking of said polymer is undertaken; knowing that said polymer, after crosslinking, must be optically transparent.

4. Method according to Claim 3, in which said polymer is the same material as that of said first polarizer (10).

5. Method according to Claims 1 or 2, in which said textured polarizer (20) is fabricated by a method in which:
- a first polarizer (10) is supplied;
- the desired texture is imparted to one of its surfaces so as to obtain said textured surface, for example with the aid of a textured pad or a roll.

6. Display device with integrated photovoltaic cells (1) and light concentrators (3) obtained by the method according to any one of Claims 1 to 5, **characterized in that** it comprises, in order and following the direction of the emitted light:
- a light source (6), such as a luminous plate;
- optionally a collimation device (13), which can comprise a plurality of individual films;
- a polarizer (11) termed the "second polarizer";
- an electro-optical modulator (5);
- a polarizer termed the "first polarizer" (10);
- a textured optical layer (9) in contact with the first polarizer (10), which advantageously exhibits an optical index which is identical to that of the first polarizer (10) or different therefrom by less than ±0.05;
- an array of optical concentrators (3) able to focus the light (6) in orifices (7);
- an array (4) of coloured image zones;
- an array (8) of zones of photovoltaic cells and of transparent zones termed "orifices" (7) between the zones of photovoltaic cells (1);
- a substrate (2) which protects said array of zones (8) of photovoltaic cells, and on which said zones of photovoltaic cells may have been deposited during their fabrication.

7. Display device with integrated photovoltaic cells (1) and light concentrators (3) obtained by the method according to any one of Claims 1 to 5, **characterized in that** it comprises, in order and following the direction of the emitted light:
- a light source (6), such as a luminous plate;
- optionally a collimation device (13), which can comprise a plurality of individual films;
- a polarizer (11) termed the "second polarizer";
- an electro-optical modulator (5);
- an array (4) of coloured image zones;
- a polarizer termed the "first polarizer" (10);
- a textured optical layer (9) in contact with the first polarizer (10), which advantageously exhibits an optical index which is identical to that of the first polarizer (10) or different therefrom by less than ±0.05;
- an array of optical concentrators (3) able to focus the light (6) in orifices (7);
- an array (8) of zones of photovoltaic cells and of transparent zones termed "orifices" (7) between the zones of photovoltaic cells (1);
- a substrate (2) which protects said array of zones (8) of photovoltaic cells, and on which said zones of photovoltaic cells may have been deposited during their fabrication.

8. Display device according to Claim 6 or 7, **characterized in that** said optical concentrators consist of one or more plane, concave or convex surfaces, and of parabolic, conical, pyramidal, tetrahedral, semicylindrical or cylindro-parabolic shapes.

9. Fixed or portable electronic apparatus, **characterized in that** it comprises a display device according to any one of Claims 6 to 8.
